# FASCICULE DE BREVET EUROPEEN

(11) **EP 1 031 987 B1**
(45) Date de publication et mention de la délivrance du brevet: **09.11.2005**
(21) Numéro de dépôt: 99103806.8
(22) Date de dépôt: 26.02.1999
(51) Int. Cl.: G11C 8/00, G11C 7/00

(54) **Mémoire électronique et dispositif électronique muni d'une telle mémoire**
Elektronischer Speicher und elektronische Anordnung mit solchem Speicher
Electronic memory and electronic device having such a memory

(43) Date de publication de la demande: 30.08.2000
(73) Titulaire: EM Microelectronic-Marin SA, 2074 Marin (CH)
(72) Inventeur: Fuentes, Vincent, 2025 Chez-le-Bart (CH)
(74) Mandataire: Ravenel, Thierry Gérard Louis

(56) Documents cités:
- US-A- 5 724 551
- PATENT ABSTRACTS OF JAPAN vol. 004, no. 146 (P-031), 15 octobre 1980 & JP 55 093595 A (HITACHI LTD), 16 juillet 1980

## Description

La présente invention concerne une mémoire électronique et un dispositif électronique muni d'une telle mémoire. En particulier, l'invention concerne la protection des données contenues dans une mémoire électronique et la gestion de l'accès à ces données ou à la possibilité d'écriture dans cette mémoire.

Le document US 5,724,551 décrit une mémoire d'ordinateur dont l'accès aux blocs de mémoire est protégé par une clé de protection. La séquence de cette clé de protection comprend notamment deux bits pour différencier quatre types d'accès envisagés à un bloc mémoire, comme représenté à la figure 15 de D1. On remarquera que la séquence "00" bloque totalement l'accès alors que la séquence "11" donne un accès en lecture et en écriture, c'est à dire le plus large accès au bloc mémoire.

De manière générale, les blocs de mémoire ou les séquences de bit formant une mémoire sont protégés, le cas échéant, par un ou deux bit(s) de protection ou d'accès. Le niveau de protection assuré par ces bits de protection est relativement moyen étant donné qu'il est possible d'altérer leur état par une action physique, notamment par une élévation de température, un rayonnement ultraviolet ou une autre action engendrant un même résultat. On notera que ces actions physiques peuvent être volontaires dans le but d'enlever la protection pour avoir un accès aux données de la mémoire, soit pour les lire, soit pour écrire d'autres données dans la mémoire. Toutefois, on remarquera qu'une mémoire peut aussi être soumise à une action physique susmentionnée par une variation non prévue des conditions environnant cette mémoire, notamment pour ce qui concerne l'élévation de température.

Le but de la présente invention est de fournir une mémoire équipée de moyens de protection présentant un niveau de sécurité supérieure. En particulier, le but de la présente invention est de pallier à la diminution de la protection pouvant résulter d'une action physique sur la mémoire.

A cet effet, la présente invention concerne une mémoire électronique comprenant au moins un bloc associé à des moyens de protection pour gérer l'accès aux données comprises dans ce bloc, cette mémoire étant caractérisée en ce que ces moyens de protection comprennent une séquence de protection d'au moins deux bits et une unité de décision qui ferme l'accès audit bloc lorsque les états logiques des bits de ladite séquence sont identiques. Il résulte de ces caractéristiques que toute action physique sur la mémoire et plus particulièrement sur les séquences de protection engendre un d'accès aux données protégées dans la mémoire. En effet, les actions physiques ont généralement pour conséquence de mettre l'ensemble des bits soumis à cette action au même état logique, c'est-à-dire soit à l'état logique "0", soit à l'état logique "1".

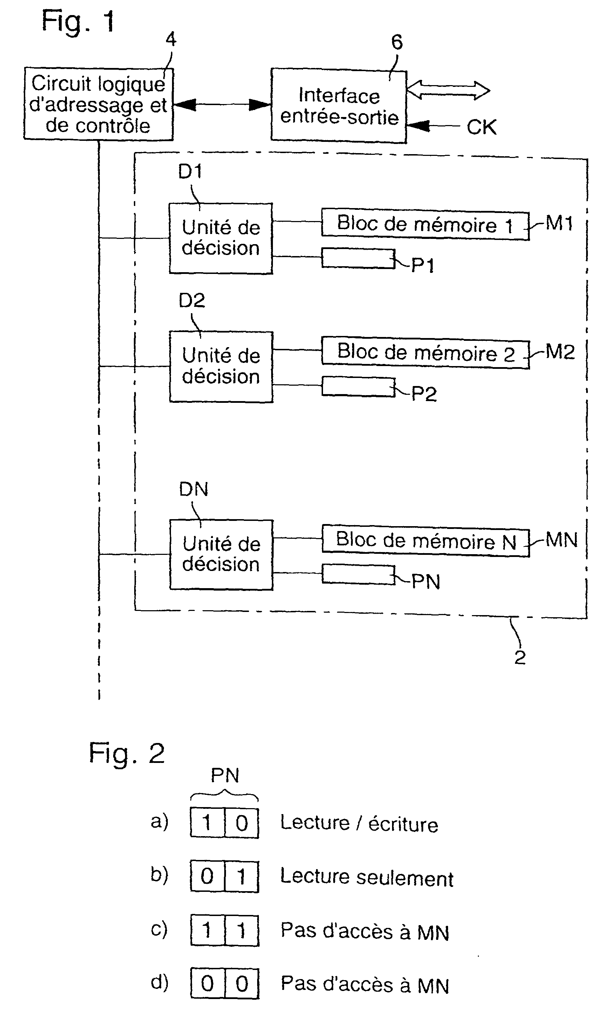

La présente invention sera décrite si après plus en détail à l'aide des figures 1 et 2 qui sont données à titre d'exemple nullement limitatif, et dans lesquels :
- la figure 1 représente schématiquement un dispositif électronique comprenant une mémoire électronique selon l'invention;
- la figure 2 donne les états possibles pour la séquence de protection de chaque bloc de mémoire et le type d'accès possible.

A la figure 1 est représenté un dispositif électronique, comprenant une mémoire électronique 2 et un circuit électronique comprenant notamment un circuit logique d'adressage et de contrôle 4 pour gérer l'accès aux diverses parties de la mémoire 2. Le circuit logique 4 est relié à un interface entrée/sortie des données soit destinées à être lues, soit destinées à être introduites dans une partie de la mémoire 2, notamment dans un bloc mémoire MN. L'interface entrée/sortie est en liaison avec des dispositifs et circuits électroniques périphériques. De plus, il est cadencé au moyen d'une horloge CK.

La mémoire électronique 2 est formée d'une pluralité de blocs de mémoire M1, M2, ..., MN. Chaque bloc de mémoire est associé à une unité de décision D1, respectivement D2, ..., DN. La pluralité de blocs de mémoire M1, M2, ..., MN sont associés respectivement à une pluralité de séquences de protection P1, P2, ..., PN. On notera que la représentation de chaque bloc mémoire associé à une unité de décision et à une séquence de protection est tout à fait schématique et donnée à titre d'exemple uniquement. Tout agencement connu de l'homme du métier et garantissant un accès au bloc mémoire en fonction du code inscrit dans la séquence de protection associée peut être prévue sans sortir du cadre de la présente invention. Notamment, dans une variante, il est prévu que les unités de décision D1 à DN forment un seul et même circuit intégré au niveau du circuit logique d'adressage et de contrôle 4.

Selon l'invention, chaque séquence de protection P1 à PN comprend au moins deux bits, comme cela est représenté à la figure 2 pour la séquence PN. De plus, selon l'invention, il est prévu que les codes de la séquence de protection qui permettent un accès au bloc mémoire correspondant MN comprennent des états logiques différents. Ainsi, pour autoriser une lecture et/ou écriture d'un bloc mémoire, le code de protection est formé par un premier bit ayant un état logique "1" et un second bit ayant un état logique "0". Pour autoriser une lecture seulement, le premier bit du code de protection et/ou écriture d'un bloc mémoire, le code de protection est formé par un premier bit ayant un état logique "1" et un second bit ayant un état logique "0". Pour autoriser une lecture seulement, le premier bit du code de protection est à l'état logique "0" alors que le second bit est à l'état logique "1". Les deux codes restant, c'est-à-dire les deux cas où les états logiques des premier et second bits de la séquence de protection sont soit à "1", soit à "0", n'autorisent aucun accès au bloc de mémoire MN.

Selon un mode de réalisation particulier, il est prévu que les séquences de protection P1 à PN sont programmables. Ainsi, un utilisateur autorisé ou le fabricant de la mémoire électronique peut programmer pour chaque bloc de mémoire séparément soit un accès lecture seulement (Read only), soit un accès lecture et/ou écriture (Read/Write). Pour ce faire, la mémoire électronique est reliée électriquement à un circuit électronique de programmation, lequel peut faire partie du dispositif électronique muni de la mémoire électronique selon l'invention. La programmation des séquences de protection P1 à PN est protégée notamment par l'introduction d'un code d'accès.

Dans le cas où ce code est formé par une séquence de bits, il est prévu de préférence que, selon la présente invention, tout accès aux séquences de protection soit interdit lorsque les états logiques du code d'accès sont identiques. On applique ainsi la présente invention a un niveau hiérarchique supérieur, les séquences de protection définissant des blocs de mémoire programmables à protéger contre une action physique.

## Revendications

1. Mémoire électronique (2) comprenant au moins un bloc (MN) associé à des moyens de protection (PN, DN) pour gérer l'accès aux données comprises dans ce bloc, **caractérisée en ce que** ces moyens de protection comprennent une séquence de protection (PN) d'au moins deux bits et une unité de décision (DN) qui ferme l'accès audit bloc lorsque les états logiques des bits de ladite séquence de protection sont identiques.

2. Mémoire électronique selon la revendication 1, **caractérisée en ce que** ladite séquence de protection est susceptible d'être programmée soit pour un accès lecture seulement (Read only), soit pour un accès lecture/écriture (Read/Write).

3. Mémoire électronique selon la revendication 1 ou 2, **caractérisée en ce que** ladite séquence de protection est programmable.

4. Dispositif électronique muni d'un circuit électronique et d'une mémoire électronique selon l'une des revendications 1 à 3.

5. Dispositif électronique selon la revendication 4, **caractérisée en ce que** ladite mémoire électronique comprend une pluralité de blocs associés respectivement à une pluralité de séquences de protection.

6. Dispositif électronique selon la revendication 5, **caractérisé en ce qu'**au moins une partie des séquences de protection de ladite pluralité de séquence de protection est programmable, ledit circuit électronique étant agencé pour permettre à un utilisateur autorisé ou au fabricant de programmer les séquences de protection programmables, cette opération étant protégée par des moyens de protection spécifiques.

7. Dispositif électronique selon la revendication 6, **caractérisé en ce que** lesdits moyens de protection spécifiques sont également formés par une séquence de bits définissant un code d'accès aux séquences de protection, tout accès à ces séquences de protection étant interdit lorsque les états logiques dudit code d'accès sont identiques.

## Patentansprüche

1. Elektronischer Speicher (2), der wenigstens einen Block (MN) umfasst, dem Schutzmittel (PN, DN) zugeordnet sind, um den Zugriff auf die in diesem Block enthaltenen Daten zu steuern, **dadurch gekennzeichnet, dass** diese Schutzmittel eine Schutzsequenz (PN) aus wenigstens zwei Bits und eine Entscheidungseinheit (DN), die den Zugriff auf den Block sperrt, wenn die logischen Zustände der Schutzsequenz-Bits gleich sind, umfassen.

2. Elektronischer Speicher nach Anspruch 1, **dadurch gekennzeichnet, dass** die Schutzsequenz entweder für einen Nur-Lese-Zugriff (Read Only) oder für einen Lese-Schreib-Zugriff (Read/Write) programmiert sein kann.

3. Elektronischer Speicher nach Anspruch 1 oder 2, **dadurch gekennzeichnet, dass** die Schutzsequenz programmierbar ist.

4. Elektronische Vorrichtung, die mit einer elektronischen Schaltung und einem elektronischen Speicher nach einem der Ansprüche 1 bis 3 versehen ist.

5. Elektronische Vorrichtung nach Anspruch 4, **dadurch gekennzeichnet, dass** der elektronische Speicher mehrere Blöcke umfasst, denen jeweils mehrere Schutzsequenzen zugeordnet sind.

6. Elektronische Vorrichtung nach Anspruch 5, **dadurch gekennzeichnet, dass** wenigstens einige der mehreren Schutzsequenzen programmierbar sind, wobei die elektronische Schaltung so beschaffen ist, dass sie einem autorisierten Anwender oder dem Hersteller ermöglicht, die programmierbaren Schutzsequenzen zu programmieren, wobei diese Operation durch spezifische Schutzmittel geschützt ist.

7. Elektronische Vorrichtung nach Anspruch 6, **dadurch gekennzeichnet, dass** die spezifischen Schutzmittel ebenfalls durch eine Bitsequenz gebildet sind, die einen Code für den Zugriff auf die Schutzsequenzen definieren, wobei jeder Zugriff auf diese Schutzsequenzen verboten ist, wenn die logischen Zustände des Zugriffscodes gleich sind.

## Claims

1. Electronic memory (2) including at least one block (MN) associated with protective means (PN, DN) for controlling access to data comprised in said block, **characterised in that** said protective means include a protective sequence (PN) of at least two bits and a decision unit (DN) which closes access to said block when the logic states of the bits of said sequence are identical

2. Electronic memory according to claim 1, **characterised in that** said protective sequence is capable of being programmed either for read only access or for read/write access.

3. Electronic memory according to claim 1 or 2, **characterised in that** said protective sequence is programmable.

4. Electronic device fitted with an electronic circuit and an electronic memory according to any of claims 1 to 3.

5. Electronic device according to claim 4, **characterised in that** said electronic memory includes a plurality of blocks associated respectively with a plurality of protective sequences.

6. Electronic device according to claim 5, **characterised in that** at least a portion of the protective sequences of said plurality of protective sequences is programmable, said electronic circuit being arranged to allow an authorised user or a manufacturer to programme the programmable protective sequences, this operation being protected by specific protective means.

7. Electronic device according to claim 6, **characterised in that** said specific protective means are also formed by a sequence of bits defining an access code to the protective sequences, any access to said protective sequences being prohibited when the logic states of said access code are identical.
